# EUROPÄISCHE PATENTSCHRIFT

(11) **EP 2 796 021 B1**
(45) Veröffentlichungstag und Bekanntmachung des Hinweises auf die Patenterteilung: **11.05.2016**
(21) Anmeldenummer: 12784520.4
(22) Anmeldetag: 23.10.2012
(51) Int. Cl.: H05K 5/00

(54) **ELEKTRONIKMODUL FÜR EIN FAHRZEUG**
ELECTRONICS MODULE FOR A VEHICLE
MODULE ÉLECTRONIQUE POUR VÉHICULE

(30) Priorität: 21.12.2011 DE 102011089474
(43) Veröffentlichungstag der Anmeldung: 29.10.2014
(73) Patentinhaber: Robert Bosch GmbH, 70442 Stuttgart (DE)
(72) Erfinder: OTT, Harald, 71691 Freiberg am Neckar (DE)
(86) Internationale Anmeldenummer: PCT/EP2012/070934
(87) Internationale Veröffentlichungsnummer: WO 2013/091941

(56) Entgegenhaltungen:
- DE-A1- 10 130 833
- DE-A1- 19 817 198
- DE-A1-102005 015 717
- DE-C1- 10 100 823

## Beschreibung

Die vorliegende Erfindung betrifft Elektronikmodule für Fahrzeuge. Insbesondere betrifft die vorliegende Erfindung ein Elektronikmodul zur Steuerung eines Getriebeteils bzw. einer Getriebekomponente. Das Elektronikmodul kann hierbei insbesondere im Getriebe angeordnet sein. Weiter insbesondere betrifft die vorliegende Erfindung ein Elektronikmodul insbesondere zum Betrieb in Getriebeflüssigkeit, ein Getriebe-Steuergerät für ein Fahrzeug, ein Getriebe für ein Fahrzeug sowie ein Fahrzeug, insbesondere ein Automobil.

### Stand der Technik

Bekannte Elektronikmodule für Fahrzeuge werden meist als hermetisch dichte Baugruppen realisiert. Hierbei findet meist ein Stahlgehäuse Verwendung, welches Kontaktpins aufweist, die in die Gehäusewandung eingeglast sind und somit den Innenbereich und den Außenbereich des Elektronikmoduls leitfähig verbinden.

Weiterführende elektrische Verbindungstechnik zu den einzelnen Funktionselementen des Elektronikmoduls, z.B. Sensoren sowie Steckverbinder, wird meist mit sogenannten Stanzgittern oder auch mit Kabelverbindungen, insbesondere bei weit entfernt liegenden Funktionselementen, realisiert.

Bekannte Elektronikmodule bestehen meist aus auf einem Bauteileträger angeordneten elektronischen Bauelementen, welcher Bauteileträger wiederum auf eine Modulleiterplatte aufgebracht, z.B. aufgeklebt, und im Weitern mit dieser elektrisch kontaktiert ist. Hierbei findet beispielsweise Bonden, Löten oder Leitkleben Anwendung.

Zum Schutz der Bauelemente wird abschließend ein Deckel auf die Leiterplatte aufgesetzt und beispielsweise durch einen Elastomerring oder eine Kunststoffraupe abgedichtet. Die Befestigung von Deckel und Modulleiterplatte erfolgt entweder durch die Klebstoffraupe oder durch zusätzliche mechanische Befestigungselemente, z.B. Nieten.

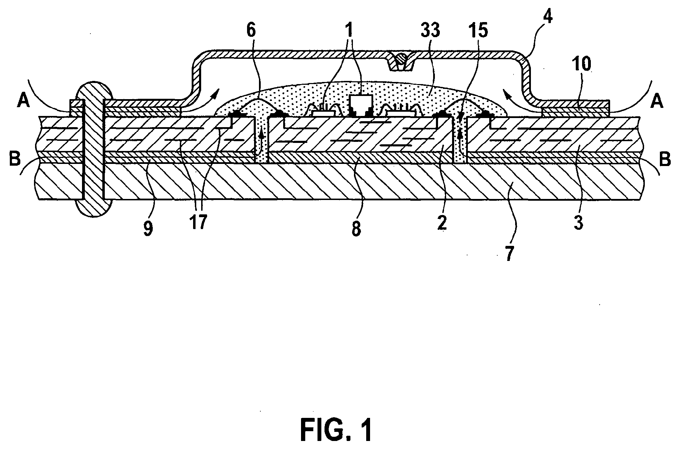

Figur 1 zeigt eine weitere exemplarische Ausgestaltung eines herkömmlichen Elektronikmoduls. Hierbei ist ein Schichtaufbau dergestalt realisiert, dass auf einem Trägerelement 7 ein Plattenelement 3 und darüber liegend ein Abdeckelement 4 aufgebracht ist. Als Trägerelement 7 kann exemplarisch eine Aluminiumplatte mit 3-4 mm Blechstärke Verwendung finden. Auf das Trägerelement 7 wird in einer Aussparung 15 des Plattenelements 3 ein Schaltungsträgerelement 2 mit elektronischen Bauelementen 1 aufgebracht und mit einem Wärmeleitklebstoff 8, z.B. Q1, auf dem Trägerelement 7 aufgeklebt. Schaltungsträgerelement 2 kann hierbei als Niedertemperatur-Einbrand-Keramik (Low Temperature Cofired Ceramics LTCC) oder eine Mikroleiterplatte realisiert sein.

Das Plattenelement 3 weist Aussparung 15 auf, in welche das Schaltungsträgerelement 2 eingebracht werden kann. Plattenelement 3 ist auf dem Trägerelement unter Verwendung von Klebstoff 9, flüssig oder als Klebband, öldicht und breitflächig oder nur partiell im Bereich des Schaltungsträgerelementes 2 und des Abdeckelementes 4 aufgeklebt. Der Innenbereich kann zumindest tw. mit einem Vergussmaterial 33 befüllt sein.

Plattenelement 3 realisiert die elektrische Verbindungstechnik zwischen dem Innenbereich des Elektronikmoduls, somit der dort angeordneten elektronischen Bauteile 1, und den außenliegenden Funktionselementen, wie beispielsweise Stecker und Sensoren, welche in Figur 1 jedoch nicht dargestellt sind. Hierzu können im Inneren des Plattenelements 3 Leiterelemente 17 vorgesehen sein, welche unter Verwendung von Verbindungselementen 6, z.B. Bonds, mit den Elementen 1 des Schaltungsträgerelementes 2 verbunden sind.

Um die elektronischen Bauteile 1 sowie die Verbindungselemente 6 vor Getriebeöl, Metallspänen sowie leitenden Ablagerungen im Getriebeöl zu schützen, wird ein Abdeckelement 4 unter Verwendung einer Dichtklebverbindung 10 auf dem Plattenelement 3 befestigt. Gegenüber der zuvor beschriebenen exemplarischen Ausgestaltung eines bekannten Elektronikmoduls ermöglicht das Elektronikmodul gemäß Figur 1 zwar eine verbesserte Abgabe von im Innenraum des Elektronikmoduls generierter Verlustwärme, jedoch weist das Elektronikmodul in Figur 1 konstruktionsbedingt zwei mögliche Leckagepfade für Getriebeöl auf. Pfad A stellt hierbei die Dichtung 10 zwischen Abdeckelement 4 und Plattenelement 3 dar, während Pfad B die Dichtung 9 zwischen Plattenelement 3 und Trägerelement 7 betrifft.

Durch beispielsweise unterschiedliche Wärmeausdehnung von Plattenelement 3 und Trägerelement 7 kann die breite Klebung 9 auf Scherung beansprucht werden, was beispielsweise zum partiellen Versagen durch Delamination und somit Beeinträchtigung der Dichtheit führen kann. Bei dem Montageprozess wird das möglicherweise empfindliche Schaltungsträgerelement 2 der elektronischen Bauelemente bei der Modulmontage auf das Trägerelement 7 aufgeklebt und ausgehärtet. Wird ein Wärmeprozess zur Aushärtung benötigt, muss das gesamte Modul den Prozess durchlaufen.

### Offenbarung der Erfindung

Ein Aspekt der vorliegenden Erfindung kann darin gesehen werden, dass ein Elektronikmodul bereitgestellt wird, welches einerseits eine gute Verlustwärmeabfuhr von im Innenraum des Elektronikmoduls angeordneten elektronischen Bauelementen bereitstellt, während der mechanische Aufbau des Elektronikmoduls nur eine Dichtstelle des Gehäuses bzw. Abdeckelementes bei gleichzeitig einfachem Aufwand und unter Verwendung bewährter bzw. bekannter Bauteile aufweist.

Demgemäß wird ein Elektronikmodul für ein Fahrzeug, ein Getriebesteuergerät, ein Getriebe sowie ein Fahrzeug, insbesondere ein Automobil gemäß den unabhängigen Ansprüchen angezeigt. Bevorzugte Ausgestaltungen ergeben sich aus den abhängigen Ansprüchen.

Das erfindungsgemäße Elektronikmodul ist hierbei derart konzipiert, dass das Schaltungsträgerelement im Abdeckelement angeordnet ist bzw. mit diesem in wärmeleitendem Kontakt steht, beispielsweise auf dieses insbesondere mit einem Wärmeleitkleber aufgeklebt ist. Gegenüber bekannten Elektronikmodulen ist somit das Schaltungsträgerelement nicht auf dem Plattenelement, sondern auf dem Abdeckelement angebracht.

Das Abdeckelement kann hierbei bevorzugt aus einem Metall bestehen und so für eine bevorzugte Verlustwärmeabgabe der vom Schaltungsträgerelement erzeugten Wärme dienen.

Das Plattenelement mit intern angeordneten Leiterelementen 17 wird dabei weiterhin verwendet, um die elektronischen Bauteile im Inneren des Elektronikmoduls mit außenliegenden Sensoren, Aktuatoren und dergleichen zu kontaktieren.

Hierbei kann zwischen dem Schaltungsträgerelement und dem Plattenelement eine geeignete Board to Board Verbindung eingerichtet sein, welche beispielsweise beim Montageprozess des Abdeckelementes auf das Plattenelement automatisch eine Verbindung zwischen den elektronischen Bauelementen des Schaltungsträgerelementes und den Leiterelementen des Plattenelementes bereitstellt.

Automatisch mag in diesem Zusammenhang insbesondere derart verstanden werden, dass bei der Montage die beiden Elemente Abdeckelement und Plattenelement in ihren zu montierenden Zustand bzw. ihre relative Anordnung zueinander gebracht werden und hierbei die elektrische Verbindung zwischen Schaltungsträgerelement und Plattenelement durch die Board to Board Verbindung automatisch, somit ohne einen separaten Verbindungsprozess, wie er beispielsweise bei Bonds oder Kabelverbindungen benötigt wird, hergestellt wird. Geeignete Board to Board Verbindungen, welche die automatische Konnektierung zwischen Schaltungsträgerelement und Plattenelement bereitstellen, sind beispielsweise geeignete Steckverbindungen, aufweisend ein Steckerelement und ein Buchsenelement, welche auf dem Schaltungsträgerelement bzw. dem Plattenelement angeordnet sind. So erfolgt durch die Montage von Abdeckelement und Plattenelement das automatische Verbinden, beispielsweise durch automatisches Einstecken eines Steckerelements in das Buchsenelement der Board to Board Verbindung.

Ein Schaltungsträgerelement kann nach Anbringung auf dem Abdeckelement nachfolgend mit einem geeigneten Gel vergossen werden. Hierbei können die Anschlusselemente der Board to Board Verbindung aus dem Gel herausstehen und ermöglichen dadurch eine Prüfung des im Abdeckelement vergossenen Schaltungsträgerelementes. Bei der nachfolgenden Montage auf dem Plattenelement, ermöglicht die erfindungsgemäße Board to Board Verbindung das automatische Herstellen einer leitfähigen Verbindung zwischen Schaltungsträgerelement und Plattenelement im gleichen Herstellungsschritt wie die dichte Montage von Abdeckelement auf dem Plattenelement. Entsprechende Verbindungstechnik für die erfindungsgemäße Board to Board Verbindung stellen hierbei federnde bzw. Toleranzen ausgleichende Steckverbinder dar, welche auch eine gleichzeitige selbstzentrierende Eigenschaft aufweisen können.

Beispielsweise im Falle eines metallischen Abdeckelementes sowie einer daran angebrachten Wärmesenke kann bevorzugt Verlustenergie bzw. Verlustwärme der elektrischen Bauteile des Schaltungsträgerelementes über dieses metallische Abdeckelement und die ggf. angebrachte Wärmesenke abgegeben werden. Das erfindungsgemäße Elektronikmodul eignet sich somit ebenso für Hochstromanwendungen wie beispielsweise die Ansteuerung von elektrischen Ölpumpen in einem Getriebe.

Ausführungsformen der Erfindung sind in den Zeichnungen dargestellt und in der nachfolgenden Beschreibung näher erläutert.

Es zeigen
- Figur 1: ein herkömmliches Elektronikmodul;
- Figur 2-4: exemplarische Ausgestaltungen eines Elektronikmoduls gemäß der vorliegenden Erfindung; und
- Figuren 5a-c: eine exemplarische Ausgestaltung eines elektrischen Verbindungselementes gemäß der vorliegenden Erfindung.

### Ausführungsformen der Erfindung

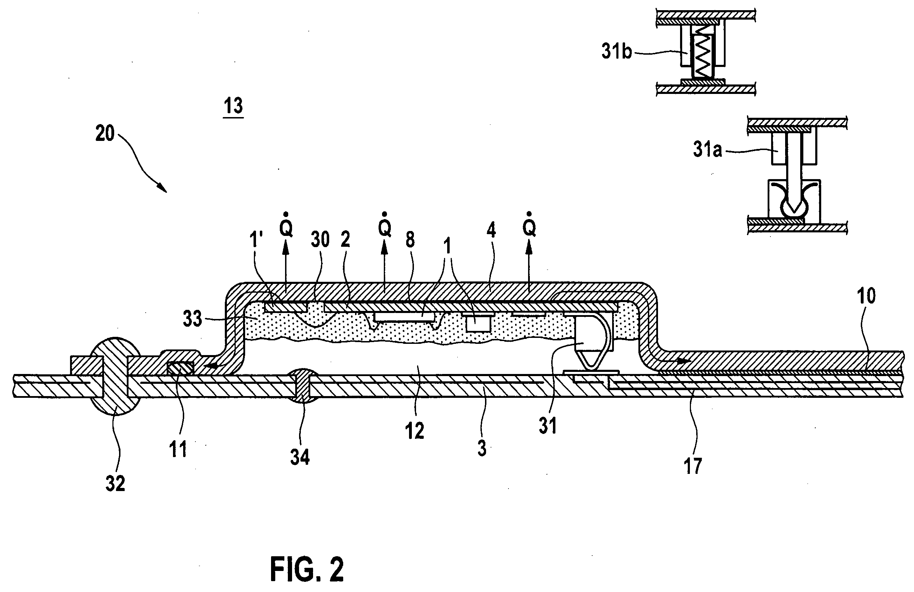

Weiter Bezug nehmend auf Figur 2 wird eine exemplarische Ausgestaltung eines Elektronikmoduls gemäß der vorliegenden Erfindung dargestellt.

Der erfindungsgemäße Schichtaufbau eines Elektromoduls gemäß der vorliegenden Erfindung stellt sich in Figur 2 wie folgt dar. Auf ein Plattenelement 3 folgt ein Abdeckelement 4, welches durch seine langgezogenen, auf dem Plattenelement 3 aufliegenden Seitenflächen auch die Funktion eines Trägerelementes übernehmen kann. Exemplarisch kann als Abdeckelement 4 ein Aluminium- oder Stahlblech mit 1-2 mm Blechstärke, ggf. verstärkt durch Sicken, verwendet werden. Das Abdeckelement 4 kann maximal die Ausmaße des gesamten Elektronikmoduls 20 begrenzen oder aber kann auf den relevanten Bereich des Schaltungsträgerelementes 2 sowie eine Befestigung von Abdeckelement 4 und Plattenelement 3 begrenzt sein.

Auf einem wannenförmigen Boden 30 des möglicherweise metallischen Abdeckelementes 4, welches exemplarisch durch Tiefziehen hergestellt werden kann, ist Schaltungsträgerelement 2, z.B. eine LTCC oder Mikroleiterplatte, mit elektronischen Bauelementen 1 befestigt. Zur Befestigung kann beispielsweise ein Wärmeleitkleber 8 verwendet werden.

Auf dem Schaltungsträgerelement 2 angeordnet ist weiterhin eine Board to Board Verbindung 31, somit ein elektrisches Verbindungselement, welches die elektrischen Bauelemente 1 mit dem Plattenelement 3 elektrisch verbindet. Diese elektrischen Verbindungselemente 31 können exemplarisch als mikromechanische Bauelemente in verschiedenen Ausführungsformen ausgeführt sein. Erfindungswesentlich ist hierbei, dass bei Montage von Abdeckelement 4 und Plattenelement 3 die leitfähige Verbindung zwischen Schaltungsträgerelement 2 und Plattenelement 3, insbesondere dessen Leiterelemente 17 automatisch erfolgt. Automatisch in diesem Zusammenhang soll verstanden werden als die Bereitstellung einer elektrischen Verbindung ohne weitere Arbeitsschritte, insbesondere ohne beispielsweise eine separate Lötverbindung oder dergleichen durch Bonds bzw. einem Kabelelement, welche erst einen Befestigungsschritt auf Plattenelement 3 benötigt.

Elektrisches Verbindungselement 31 ist exemplarisch als eine federnde Blechzunge ausgebildet, während elektrisches Verbindungselement 31a vergleichbar einem Messer/Gabel-Kontakt funktioniert. Elektrisches Verbindungselement 31b ist weiterhin exemplarisch als ein federnder Pin ausgebildet.

Derartige Board to Board Verbindungen lassen sich kostengünstig beispielsweise als SMD-Bauteil auf dem Schaltungsträgerelement 2 befestigen, beispielsweise durch einen Reflow-Lötprozess. Entsprechende Board to Board Verbindungen sind in einer Signalvariante, somit eine Niedrigleistungsvariante, als auch eine Powervariante oder Hochleistungsvariante realisierbar.

Im Plattenelement 3 befinden sich innenliegend Leiterelemente 17. Beispielsweise kann Plattenelement 3 als ein herkömmliches Leiterplattenelement mit innenliegenden, von einzelnen Laminatschichten geschützten Kupferleitern 17 realisiert sein. Die Leiterelemente 17 realisieren hierbei die elektrische Verbindungstechnik zwischen dem Innenraum 12 des Elektronikmoduls 20 und dem Außenraum 13, somit zwischen den elektrischen Bauteilen 1 und den außenliegenden Funktionselementen wie z.B. in Figur 2 nicht dargestellten Steckern und Sensoren.

Eine Abdichtung von Plattenelement 3 und Abdeckelement 4 kann entweder durch eine Klebung 10, insbesondere eine Dichtklebung, oder alternativ durch eine Elastomerabdichtung 11 realisiert werden. Hierbei wird das Abdeckelement 4 entweder durch die Klebung 10 gehalten oder alternativ durch ein zusätzliches mechanisches Befestigungselement 32, z.B. ein Nietelement.

Zwischen dem Plattenelement 3 und Abdeckelement 4 können noch Zentrierungen vorgesehen sein, welche insbesondere eingerichtet sind, die Board to Board Verbindung des elektrischen Verbindungselementes 31 bereit zu stellen, so dass diese sicher die den elektrischen Verbindungselementen 31 gegenüberliegenden bzw. komplementären Steckverbindungen bzw. Kontaktpads auf dem Plattenelement 3 treffen.

Weiterhin dargestellt in Figur 2 ist elektronisches Bauelement 1', welches exemplarisch eine hohe Verlustwärme *Q̇* verursacht. Dieses ist separiert vom Schaltungsträgerelement 2 und den darauf angeordneten Bauelementen 1 und kann exemplarisch direkt mit dem Abdeckelement 4, z.B. mit Wärmeleitkleber, verbunden werden. Durch die direkte Anbindung von Bauelement 1' gegenüber der indirekten Anbindung der Bauelemente 1 via dem Schaltungsträgerelement 2 ist eine verbesserte Wärmeableitung für elektronisches Bauelement 1' realisierbar. Als elektrische Kontaktierungstechnik zwischen Bauelement 1' und Schaltungsträgerelement 2 kann exemplarisch Boden oder Leitkleben verwendet werden.

Zum Schutz der elektronischen Bauelemente 1, 1' und des Schaltungsträgerelementes 2 sowie deren Kontaktierungstechnik kann die Wanne 30 mit einem Vergussmaterial 33, beispielsweise einem geeigneten, aushärtenden Gel befüllt werden. Hierbei wird bevorzugt soviel Vergussmaterial 33 in die Wanne 30 des Abdeckelementes 4 eingefüllt, so dass im Wesentlichen nur noch die elektrischen Verbindungselemente 31 herausragen. Hierdurch wird eine Prüfung der Funktionalität der vergossenen elektronischen Bauelemente 1, 1' sowie Schaltungsträgerelement 2 nach dem Befüllungsvorgang des Bodens 30 von Abdeckelement 4 durch Vergussmaterial 33 ermöglicht.

Im Plattenelement 3 in Figur 2 ist exemplarisch noch ein Via 34 dargestellt, verschließbar beispielsweise durch einen Lötvorgang oder einen Pfropf, welcher nach einer erfolgten Montage von Abdeckelement 4 und Plattenelement 3 eine Dichtigkeitsprüfung, beispielsweise durch Überdruck, und/oder eine Befüllung mit einem geeigneten Inertgas ermöglicht. Gleichfalls ist eine Einbringung des Vergussmaterials 33 im montierten Zustand durch Via 34 denkbar.

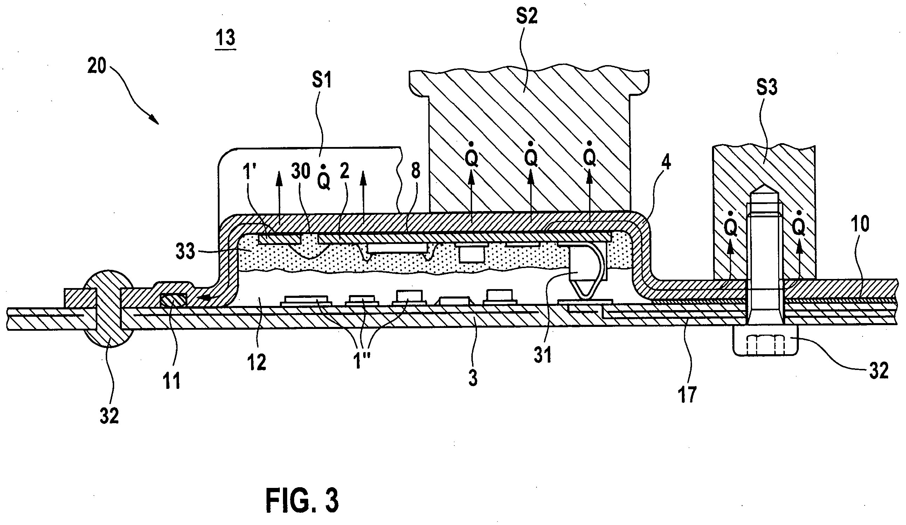

Weiter Bezug nehmend auf Figur 3 wird eine weitere exemplarische Ausgestaltung eines Elektronikmoduls gemäß der vorliegenden Erfindung dargestellt.

Hierbei entspricht Figur 3 im Wesentlichen der zuvor bezüglich Figur 2 beschriebenen Ausgestaltung. Verändert gegenüber Figur 2 ist dabei, dass auch das Plattenelement 3 weitere elektronische Bauelemente 1" aufweist, welche auch auf einem weiteren Schaltungsträger 2 angeordnet und auf Plattenelement 3 aufgebracht sein können. Eine elektrische Verbindung der elektronischen Bauelemente 1" kann beispielsweise durch die im Plattenelement 3 angeordneten Leiterelemente 17 realisiert werden. Hierbei können die elektronischen Bauelemente 1" bevorzugt Bauelemente mit niedriger Verlustwärme sein, da über das Plattenelement 3 möglicherweise weniger Verlustwärme abgeführt werden kann als beispielsweise über Abdeckelement 4, insbesondere wenn dieses als ein Metallelement ausgebildet ist.

Somit kann ein Elektronikmodul besonders kompakt in zwei Ebenen realisiert werden.

Die Verlustwärme der elektronischen Bauelemente 1, 1', 1" der Figur 3 kann entweder über Wärmesenken, z.B. Kühlrippen S1, an Luft- oder Spritzöl und/oder an eine angepresste, angelötete, angeschweißte oder angeklebte, bevorzugt metallisch ausgebildete Wärmesenke S2 abgegeben werden. Weiter in Figur 3 auf der rechten Seite dargestellt ist mechanisches Befestigungselement 32, welches exemplarisch als eine Schraubverbindung ausgebildet ist und im Weiteren eine Wärmesenke S3 auf dem Abdeckelement 4 befestigt.

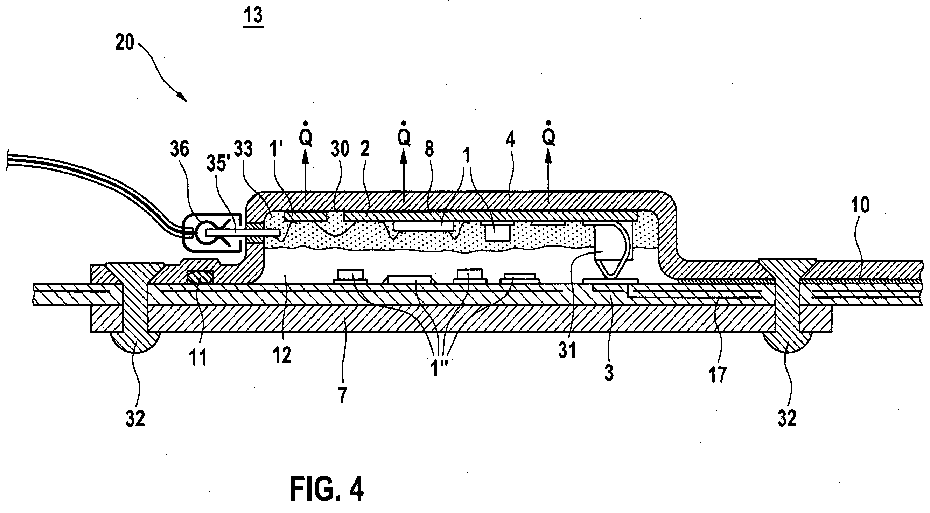

Weiter Bezug nehmend auf Figur 4 wird eine weitere exemplarische Ausgestaltung eines Elektronikmoduls gemäß der vorliegenden Erfindung dargestellt.

In Figur 4 weiter vorgesehen ist Trägerelement 7, angeordnet am Plattenelement 3 und gegenüberliegend dem Abdeckelement 4. Durch Trägerelement 7 wird beispielsweise ein mögliches Ausbeulen des Plattenelementes 3 nach außen (in Richtung des nun angebrachten Trägerelementes 7), beispielsweise hervorgerufen durch einen temperaturbedingten Innendruckanstieg, verhindert bzw. zumindest vermindert. Trägerelement 7 kann exemplarisch aus Kunststoff oder Metall ausgebildet sein. Hierbei kann Abdeckelement 4, beispielsweise als Metall ausgebildet, ebenfalls als Wärmesenke ausgebildet sein. Trägerelement 7 kann ebenfalls mittels der mechanischen Befestigungselemente 32 an Plattenelement 3 und Abdeckelement 4 angebracht sein.

Weiter ist in Figur 4 ein möglicher Pfad 35' durch Abdeckelement 4 dargestellt. Denkbar sind hierbei eingeglaste Metallstifte, welche beispielhaft an der Außenseite von Abdeckelement 4 durch eine Steckverbindung 36 oder Schweißung kontaktiert werden. Hierbei kann Pfad 35' exemplarisch ein Hochstrompfad sein, beispielsweise angeschlossen an elektrischem Hochleistungsbauelement 1'. Hierdurch muss das Platenelement 3 nicht zwingend hochstromfähig sein und mag somit kostengünstiger herstellbar sein.

Gleichfalls ist denkbar, dass Pfad 35 als ein optischer Kommunikationspfad ausgebildet ist und somit eine, z.B. galvanisch getrennte, Kommunikationsverbindung aus dem Inneren des Elektronikmoduls nach außen bereitstellen kann. In diesem Fall könnte Steckverbindung 36 als ein optischer Glasfaserleiter ausgebildet sein.

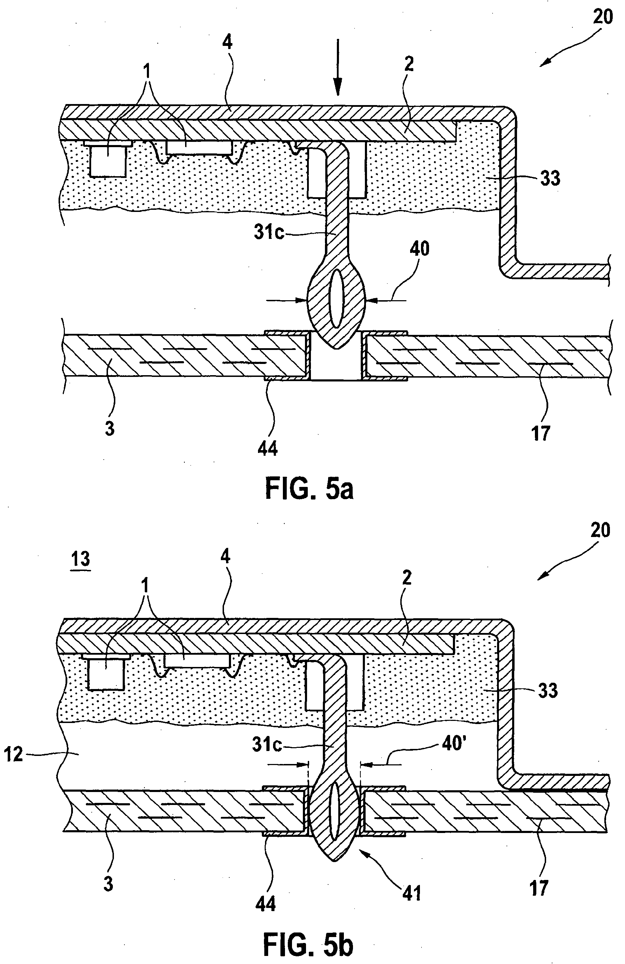

Weiter bezugnehmend auf Fig. 5a bis c wird eine exemplarische Ausgestaltung eines elektrischen Verbindungselementes gemäß der vorliegenden Erfindung dargestellt.

Fig. 5a zeigt einen Detailausschnitt von Elektronikmodul 20 mit elektrischem Verbindungselement 31c, ausgebildet als ein Pin mit einem federnden Bereich 40. Federnder Bereich 40 sowie eine Kontaktstelle 44 im Plattenelement 3 sind dabei derart aufeinander angestimmt, dass bei einem Einführvorgang die Seiten des federnden Bereiches 40 die Seitenflächen der Kontaktstelle 44 kontaktieren und somit beim Montagevorgang eine automatische Verbindung von Verbindungselement 31c und Kontaktstelle 44 realisieren.

In Fig. 5a sind die Abmaße von federndem Bereich 40 geringfügig größer als die Öffnung der Kontaktstelle 44, wobei der federnde Bereich 40 noch immer in Kontaktstelle 44 einführbar sein soll. Fig. 5a zeigt einen Zustand in dem Abdeckelement 4 und Plattenelement 3 noch nicht aufeinander aufgesetzt und somit noch nicht montiert sind. Kontaktstelle 44 kann im Weiteren mit den Leiterelementen 17 des Plattenelementes 3 elektrisch leitfähig verbunden sein.

In Fig. 5b sind Abdeckelement 4 und Plattenelement 3 aufeinander aufgesetzt und somit montiert. Hierbei wurde durch ein Eingleiten des federnden Bereichs 40 des Kontaktelementes 31c in die Kontaktstelle 44 eine leitfähige Verbindung zwischen dem Schaltungsträgerelement 2 bzw. den Bauelementen 1,1',1" und dem Leiterelement17 via Kontaktelement 31c und Kontaktstelle 44 realisiert. Im eingeführten Zustand wird der federnde Bereich 40 zusammengepresst zu federndem Bereich 40' und kommt hierdurch auf den Seitenflächen der Kontaktstelle 44 kraftschlüssig zu liegen, wodurch die elektrische Verbindung der einzelnen Komponenten 1,1',1",2,31c mit 40, 44 und 17 bereitgestellt wird.

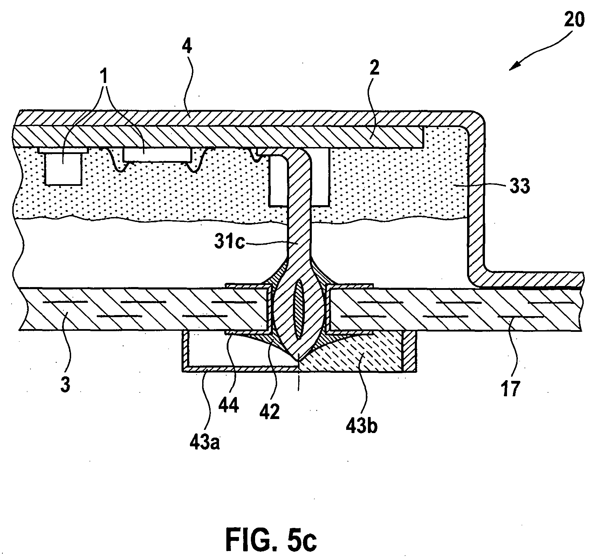

Eine Ausführung der Kontaktstelle 44 ist in den Fig. 5a-c exemplarisch undicht 41, somit das Plattenelement durchdringend dargestellt. Zur Abdichtung des Innenbereichs 12 gegenüber dem Außenbereich 13 des Elektronikmoduls 20 kann, wie in Fig. 5c dargestellt die Kontaktstelle 44 mit eingebrachtem Kontaktelement 31c geeignet verschlossen 42 werden, z.B. durch Verschweißen, einen Lötprozess oder einer geeigneten Klebung, welche auch gleichzeitig eine Isolierung bzw. Abdeckung der Kontaktstelle 44 bereitstellen kann. Alternativ kann zum Schutz der nach außen offenen Kontaktstelle am Plattenelement 3 ein weiteres Abdeckelement 43a vorgesehen sein oder aber ein Vergussrahmen angebracht werden, um die Kontaktstelle 44 mit Vergussmaterial 43b zu schützen.

Gleichfalls ist denkbar, dass Kontaktstelle 44 selbst nur eine, z.B. wannenförmige, Vertiefung im Plattenelement 3 ausbildet und dabei das Plattenelement 3 nicht vollständig sondern nur teilweise durchdringt. Abhängig von der spezifischen Ausgestaltung des federnden Bereichs 40 kann dieser auch in solch einer Ausgestaltung wie zuvor beschrieben mit den Seitenflächen der Kontaktstelle 44 in Kontakt kommen und realisiert so die leitfähige Verbindung ohne dass das Plattenelement 3 durchgehenden Öffnungen aufweisen müsste. In diesem Fall ist ein Schutz gemäß Komponenten 43a oder 43b nicht notwendig, da die Außenseite des Plattenelementes 3 durchgehend und ohne Öffnungen für Kontaktelemente 31 ausgebildet ist.

## Patentansprüche

1. Elektronikmodul (20) für ein Fahrzeug, insbesondere zum Betrieb in einem Getriebe in Getriebeflüssigkeit, aufweisend
ein Plattenelement (3);
ein Schaltungsträgerelement (2); und
ein Abdeckelement (4);
das Elektronikmodul (20) weiterhin aufweisend
einen Innenbereich (12); und
einen Außenbereich (13);
wobei das Plattenelement (3) eingerichtet ist, zumindest eine leitfähige Verbindung (17) zwischen Innenbereich (12) und Außenbereich (13) zur elektrischen Anbindung des Schaltungsträgerelementes bereitzustellen;
wobei das Schaltungsträgerelement (2) am Abdeckelement (4) angeordnet ist; und wobei zwischen Schaltungsträgerelement (2) und Plattenelement (3) zumindest ein elektrisches Verbindungselement (31) eingerichtet ist;
**dadurch gekennzeichnet, dass**
das elektrische Verbindungselement (31) als ein automatisches Verbindungselement ausgebildet ist, welches bei der Montage von Abdeckelement (4) und Plattenelement (3) automatisch eine elektrisch leitfähige Verbindung zwischen Schaltungsträgerelement (2) und leitfähige Verbindung (17) des Plattenelementes (3) bereitstellt, und das Schaltungsträgerelement (2) auf einem wannenförmigen Boden (30) des Abdeckelements (4) befestigt ist.

2. Elektronikmodul gemäß Anspruch 1,
wobei das automatische Verbindungselement (31) ausgebildet ist als ein Element aus der Gruppe bestehend aus federnd, federndes Nadelöhr, Toleranzen ausgleichend, selbstzentrierend und Steckverbindungselement.

3. Elektronikmodul gemäß einem der vorhergehenden Ansprüche,
wobei das Plattenelement (3) ausgebildet ist als ein Leiterplattenelement; und/oder wobei das Plattenelement (3) ein weiteres Schaltungsträgerelement aufweist; und/oder wobei das Plattenelement (3) elektrische Bauelemente (1 ") aufweist.

4. Elektronikmodul gemäß einem der vorhergehenden Ansprüche,
wobei am Deckelelement (4) eine Wärmesenke (S1,S2,S3) angeordnet ist; und
wobei eine Verlustwäre (Q) des Schaltungsträgerelementes (2) mittels der Wärmesenke (S1,S2,S3) abgegeben werden kann.

5. Elektronikmodul gemäß einem der vorhergehenden Ansprüche,
wobei am Plattenelement (3) zumindest in einem Teilbereich ein Trägerelement (7) angeordnet ist; und
wobei das Trägerelement (7) zur Stabilisierung und/oder zur Verlustleistungsabgabe, insbesondere des weiteren Schaltungsträgerelementes bzw. der elektrische Bauelemente (1") des Plattenelementes, eingerichtet ist.

6. Elektronikmodul gemäß einem der vorhergehenden Ansprüche;
wobei das Deckelelement (4) zumindest ein Leiterelement (35) aufweist, welches das Deckelelement (4) durchdringend ausgebildet ist; und
wobei das Deckelelement-Leiterelement (35) mit dem Schaltungsträgerelement (2) und/oder zumindest einem elektronischen Bauteil (1,1',1") verbunden ist.

7. Elektronikmodul gemäß Anspruch 6,
wobei das Deckelelement-Leiterelement (35) ausgebildet ist als elektrisches Hochleistungs-Leiterelement (35'), insbesondere Hochspannungs-Leiterelement bzw. Hochstrom-Leiterelement sowie die leitfähige Verbindung (17) des Plattenelementes als Niederleistungs-Verbindung ausgebildet ist.

8. Elektronikmodul gemäß Anspruch 6,
wobei das Deckelelement-Leiterelement (35) ausgebildet ist als optisches Leiterelement.

9. Getriebe-Steuergerät für ein Fahrzeug, aufweisend ein Elektronikmodul (20) gemäß zumindest einem der vorhergehenden Ansprüche.

10. Getriebe für ein Fahrzeug, aufweisend ein Getriebe-Steuergerät gemäß Anspruch 8 und/oder ein Elektronikmodul (20) gemäß zumindest einem der Ansprüche 1 bis 7.

11. Fahrzeug, insbesondere Automobil, aufweisend ein Getriebe gemäß Anspruch 9, ein Getriebe-Steuergerät gemäß Anspruch 8 und/oder ein Elektronikmodul (20) gemäß zumindest einem der Ansprüche 1 bis 7.

## Claims

1. Electronics module (20) for a vehicle, in particular for operation in a transmission in transmission fluid, comprising
a plate element (3);
a circuit carrier element (2); and
a covering element (4);
the electronics module (20) also comprising an inner region (12); and
an outer region (13);
wherein the plate element (3) is designed to make available at least one conductive connection (17) between the inner region (12) and the outer region (13) for electrically connecting the circuit carrier element;
wherein the circuit carrier element (2) is arranged on the covering element (4), and
wherein at least one electrical connecting element (31) is installed between the circuit carrier element (2) and the plate element (3); **characterized in that**
the electrical connecting element (31) is embodied as an automatic connecting element which automatically makes available an electrically conductive connection between the circuit carrier element (2) and the conductive connection (17) of the plate element (3) when the covering element (4) and the plate element (3) are fitted, and the circuit carrier element (2) is fastened to a through-shaped base (30) of the covering element (4).

2. Electronics module according to Claim 1,
wherein the automatic connecting element (31) is embodied as an element composed of the group comprising sprung, sprung needle eyelet, tolerance-compensating, self-centering and plug connecting element.

3. Electronics module according to one of the preceding claims,
wherein the plate element (3) is embodied as a circuit board element;
and/or
wherein the plate element (3) has a further circuit carrier element;
and/or
wherein the plate element (3) has electrical components (1").

4. Electronics module according to one of the preceding claims,
wherein a heat sink (S1, S2, S3) is arranged on the cover element (4); and
wherein dissipated heat (Q) of the circuit carrier element (2) can be output by means of the heat sink (S1, S2, S3).

5. Electronics module according to one of the preceding claims,
wherein a carrier element (7) is arranged on the plate element (3), at least in a partial region; and
wherein the carrier element (7) is designed to perform stabilization and/or to output dissipated heat, in particular from the further circuit carrier element or the electrical components (1") of the plate element.

6. Electronics module according to one of the preceding claims,
wherein the cover element (4) has at least one conductor element (35) which is designed to penetrate the cover element (4); and
wherein the cover element-conductor element (35) is connected to the circuit carrier element (2) and/or to at least one electronic component (1, 1', 1").

7. Electronics module according to Claim 6,
wherein the cover element-conductor element (35) is embodied as an electrical high-power conductor element (35'), in particular a high-voltage conductor element or high-current conductor element and the conductive connection (17) of the plate element is embodied as a low-power connection.

8. Electronics module according to Claim 6, wherein the cover element-conductor element (35) is embodied as an optical conductor element.

9. Transmission control unit for a vehicle, having an electronics module (20) according to at least one of the preceding claims.

10. Transmission for a vehicle, having a transmission control unit according to Claim 8 and/or an electronics module (20) according to at least one of Claims 1 to 7.

11. Vehicle, in particular motor vehicle, having a transmission according to Claim 9, a transmission control unit according to Claim 8 and/or an electronic module (20) according to at least one of Claims 1 to 7.

## Revendications

1. Module électronique (20) destiné à un véhicule, en particulier destiné à être utilisé dans le liquide de transmission d'une boîte de vitesse, comprenant un élément carte (3) ;
un élément support de circuits (2) ; et
un élément de recouvrement (4) ;
le module électronique (20) présentant en outre une zone intérieure (12) ; et
une zone extérieure (13) ;
dans lequel l'élément carte (3) est configuré pour établir au moins une liaison conductrice (17) entre la zone intérieure (12) et la zone extérieure (13) afin de relier électriquement l'élément support de circuits ; dans lequel l'élément support de circuits (2) est disposé sur l'élément de recouvrement (4) ; et
dans lequel au moins un élément de liaison électrique (31) est installé entre l'élément support de circuits (2) et l'élément carte (3) ;
**caractérisé en ce que** l'élément de liaison électrique (31) est réalisé sous la forme d'un élément de liaison automatique qui, lors du montage de l'élément de recouvrement (4) et de l'élément carte (3), établit automatiquement une liaison électriquement conductrice entre l'élément support de circuits (2) et la liaison conductrice (17) de l'élément carte (3), et **en ce que** l'élément support de circuits (2) est fixé à un fond en forme de cuvette (30) de l'élément de recouvrement (4).

2. Module électronique selon la revendication 1, dans lequel l'élément de liaison automatique (31) est réalisé sous la forme d'un élément choisi dans le groupe comprenant des éléments de connexion à ressort, à trou d'aiguille et à ressort, à compensation des tolérances, à centrage automatique et à fiche.

3. Module électronique selon l'une quelconque des revendications précédentes,
dans lequel l'élément carte (3) est réalisé sous la forme d'un élément carte à circuit imprimé ; et/ou dans lequel l'élément carte (3) présente un élément support de circuits supplémentaire ; et/ou dans lequel l'élément carte (3) présente des composants électriques (1").

4. Module électronique selon l'une quelconque des revendications précédentes,
dans lequel un puits thermique (S1, S2, S3) est disposé sur l'élément de recouvrement (4) ; et
dans lequel une perte thermique (Q) de l'élément support de circuit (2) peut être évacuée au moyen du puits thermique (S1, S2, S3).

5. Module électronique selon l'une quelconque des revendications précédentes,
dans lequel un élément support (7) est disposé au moins dans une région partielle sur l'élément carte (3) ; et dans lequel l'élément support (7) est conçu pour stabiliser et/ou évacuer la perte de puissance, notamment de l'élément support de circuits supplémentaire ou du composant électrique (1") de l'élément carte.

6. Module électronique selon l'une quelconque des revendications précédentes,
dans lequel l'élément de recouvrement (4) présente au moins un élément conducteur (35) qui est réalisé de manière à passer à travers l'élément de recouvrement (4) ; et
dans lequel l'élément de recouvrement-élément conducteur (35) est relié à l'élément support de circuits (2) et/ou à au moins un composant électronique (1, 1', 1").

7. Module électronique selon la revendication 6, dans lequel l'élément de recouvrement-élément conducteur (35) est réalisé sous la forme d'un élément conducteur de forte puissance électrique (35'), en particulier sous la forme d'un élément conducteur à haute tension ou d'un élément conducteur à courant fort et la liaison conductrice (17) de l'élément carte est réalisée sous la forme d'une liaison de faible puissance.

8. Module électronique selon la revendication 6, dans lequel l'élément de recouvrement-élément conducteur (35) est réalisé sous la forme d'un élément conducteur optique.

9. Appareil de commande de boîte de vitesse destiné à un véhicule, comprenant un module électronique (20) selon au moins l'une des revendications précédentes.

10. Boîte de vitesse destinée à un véhicule, comprenant un appareil de commande de boîte de vitesse selon la revendication 8 et/ou un module électronique (20) selon au moins l'une des revendications 1 à 7.

11. Véhicule, en particulier automobile, comprenant une boîte de vitesse selon la revendication 9, un appareil de commande de boîte de vitesse selon la revendication 8 et/ou un module électronique (20) selon au moins l'une des revendications 1 à 7.
